(19) Europäisches Patentamt
European Patent Office
Office européen des brevets

(11) EP 2 526 434 B1

(12) **EUROPÄISCHE PATENTSCHRIFT**

(45) Veröffentlichungstag und Bekanntmachung des Hinweises auf die Patenterteilung:
**07.01.2015 Patentblatt 2015/02**

(51) Int Cl.:
**G01R 33/16** (2006.01)  **G01R 33/18** (2006.01)

(21) Anmeldenummer: **11734388.9**

(22) Anmeldetag: **20.01.2011**

(86) Internationale Anmeldenummer:
**PCT/DE2011/000058**

(87) Internationale Veröffentlichungsnummer:
**WO 2011/088823 (28.07.2011 Gazette 2011/30)**

(54) **VERFAHREN ZUR BESTIMMUNG MECHANISCHER EIGENSCHAFTEN MAGNETOSTRIKTIVER MATERIALIEN**

METHOD FOR DETERMINING MECHANICAL PROPERTIES OF MAGNETOSTRICTIVE MATERIALS

PROCÉDÉ DESTINÉ À DÉTERMINER LES PROPRIÉTÉS MÉCANIQUES DE MATÉRIAUX MAGNÉTOSTRICTIFS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.01.2010 DE 102010005550**

(43) Veröffentlichungstag der Anmeldung:
**28.11.2012 Patentblatt 2012/48**

(73) Patentinhaber: **Christian-Albrechts-Universität zu Kiel**
**24118 Kiel (DE)**

(72) Erfinder:
• **QUANDT, Eckhard**
 **24226 Heikendorf (DE)**
• **BECHTOLD, Chrisoph**
 **24103 Kiel (DE)**
• **CHEMNITZ, Steffen**
 **24116 Kiel (DE)**
• **THEDE, Claas**
 **24106 Kiel (DE)**
• **TELIBAN, Julian**
 **24118 Kiel (DE)**

(74) Vertreter: **Appelt, Christian W.**
**Boehmert & Boehmert**
**Anwaltspartnerschaft mbB**
**Patentanwälte Rechtsanwälte**
**Pettenkoferstrasse 20-22**
**80336 München (DE)**

(56) Entgegenhaltungen:
**DE-A1- 4 218 799     US-B1- 6 433 543**

• **BECHTOLD C ET AL: "Non-contact strain measurements based on inverse magnetostriction", SENSORS AND ACTUATORS A, ELSEVIER SEQUOIA S.A., LAUSANNE, CH, Bd. 158, Nr. 2, 13. Januar 2010 (2010-01-13), Seiten 224-230, XP026964564, ONLINE ISSN: 0924-4247 [gefunden am 2010-01-13]**

EP 2 526 434 B1

**Beschreibung**

Die Erfindung betrifft ein Mess- und Auswerteverfahren, mit dem mechanische Spannungszustände magnetostriktiver Materialien bestimmt werden können.

Die Erfindung beruht auf dem magnetostriktiven Effekt. Magnetostriktive Sensoren sowie verschiedene Mess- und Signalauswerteverfahren für diese sind seit langem bekannt. Grob verallgemeinert einteilbar sind magnetostriktive Sensoren in zwei funktionale Gruppen und zwei technologische Gruppen. Die eine Gruppe nutzt den magnetostriktiven Effekt, die andere den inversen magnetostriktiven Effekt aus. In der technologischen Einteilung ist bei den einen das magnetische oder das magnetostriktive Element gegenüber dem anderen derart flexibel ausgeführt, dass bei mechanischem Druck an einem der Elementeenden der Abstand zwischen diesen verändert wird. Die Veränderung wird als Messeffekt ausgenutzt.

Verfahrungen und Vorrichtungen, die das Auswerteergebnis abstandsunabhängig von der Distanz Sensorelement/Messobjekt um ein Vielfaches des Messeffektes übersteigen, sind genauso bekannt wie Auswerteschaltungen, die ein nahezu lineares Messergebnis zum Spannungszustand des magnetostriktiven Materials liefern.

In der Offenlegungsschrift DE 35 34 460 A1 [Sensoranordnung] wird eine Anordnung beschrieben, die eine erweiterte Linearisierung der Transferkennlinie ermöglicht. Eine Messbereichslinearisierung wird ebenfalls in der DE 36 24 846 A1 [Vorrichtung zum berührungsfreien Messen einer mechanischen Spannung] beschreiben.

Die DE 36 20 412 A1 [Schaltungsanordnung zum Betreiben eines magnetoelastischen Sensors] beschreibt eine abstimmbare Schaltung, bei der der Abstand Sensorelement-Messobjekt nahezu keinen Einfluss mehr auf das Sensorsignal hat. Das US-Patent 3,898,55 [Linear Distance Measuring Device Using a Moveable Magnet Interacting with a Sonic Waveguide] benutzt eine Signallaufzeit zur Signalauswertung mit extrem hoher Signalauflösung. Als vorteilhafte Ausgestaltung wird ein Schirmsystem angegeben, wodurch die Robustheit gegenüber Umwelteinflüssen verbessert wird, als auch die EMV-Eigenschaften der Messeinrichtung.

Gemeinsam ist allen Anordnungen und Verfahren, dass die Signalauswertung entweder direkt analog oder über das Mischungsprodukt oder die Mischsumme als frequenzselektive Auswertung erfolgt. Gemeinsam nachteilig ist allen Auswerteverfahren, dass sie die Amplituden der Harmonischen der Modulationsfrequenz und deren Verlauf in Abhängigkeit des Spannungszustandes des magnetostriktiven Materials nicht betrachten und auswerten, auch nicht die Verhältnisse zwischen diesen Harmonischen. In "Non-contact strain measurement", Sensors and Actuators A 158(2010) 224-230 wird dies im online vorveröffentlichten Abstract nur teilweise angedeutet.

Der Erfindung liegt die Aufgabe zugrunde, ein Auswerteverfahren bereitzustellen, das es ermöglicht, ein zeitmoduliertes Signal zu gewinnen, das für die magnetischen Eigenschaften eines invers magnetostriktiven Materials charakteristisch ist.

Die Aufgabe wird durch ein Verfahren mit den im Anspruch 1 gelöst. Die Unteransprüche geben ebenfalls vorteilhafte Ausführungen an.

Grundgedanke des Verfahrens ist die Betrachtung bestimmter Fourier-Koeffizienten bzw. deren Nullstellen, was ein berührungsloses Auslesen über sehr große Distanzen in Bezug auf den Messeffekt ermöglicht.

Ein Ausführungsbeispiel des Verfahrens wird im Folgenden zunächst allgemein anhand von acht Figuren und einer Tabelle näher erläutert. Dabei zeigt:

- Fig. 1 eine idealisierte Magnetisierungskurve,

- Fig. 2 ein magnetisches Material im sinusförmigen Wechselmagnetfeld mit Rechteckverlauf der Suszeptibilität,

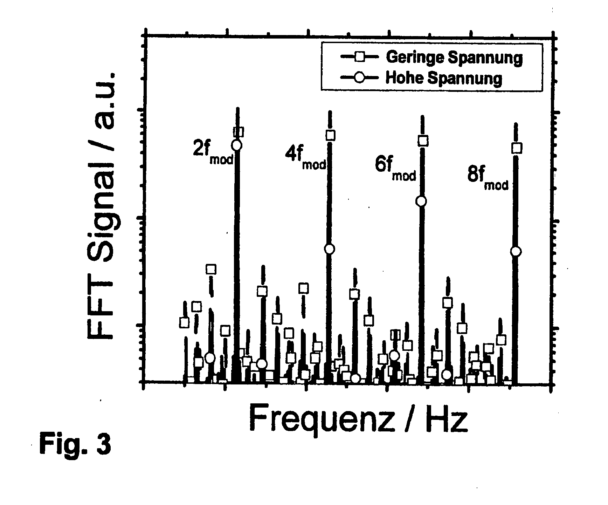

- Fig. 3 die Koeffizienten der Fourier-Reihe mit Vielfachen der doppelten Modulationsfrequenz,

- Fig. 4 die lokalen Minima in Abhängigkeit vom mechanischen Material-Spannungszustand,

- Fig. 5a die Fourier-Koeffizienten als Abstandsfunktion zwischen Material und Messspule,

- Fig. 5b die charakteristischen Minima bei Abstandsvergrößerung,

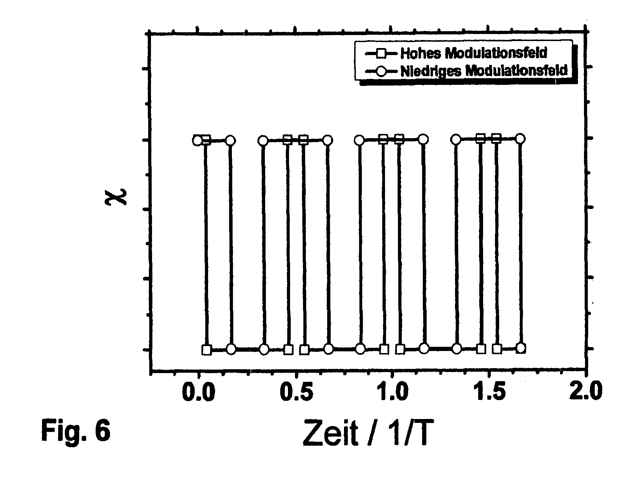

- Fig. 6 die Rechtecksignal-Tastveränderung bei variiertem $H_{mod.}$,

- Fig. 7 die Nullstellen der Fourier-Koeffizienten für verschiedene $H_{mod.}/H_k$-Verhältnisse,

- Fig. 8 das proportionales Material-Anisotropiefeld für Modulationsfeld mit Nullstellen sowie

- Tab. 1 die Nullstellenzusammenstellung nach Gleichung (8).

Ein ferromagnetisches, invers magnetostriktives Material wird einem Wechselmagnetfeld der Frequenz $f_{mod.}$ ausgesetzt. Die Größe des Wechselmagnetfeldes ist dabei so gewählt, dass das magnetische Material periodisch in die Sättigung gebracht wird. Daraus ergibt sich für die Magnetisierungskurve, dargestellt als Magnetisierung M des Materials als Funktion der externen Feldstärke $H_{ext.}$, ein charakteristischer Verlauf der Suszeptibilität $x(= \frac{\partial M}{\partial H_{ext.}})$ über die Zeit.

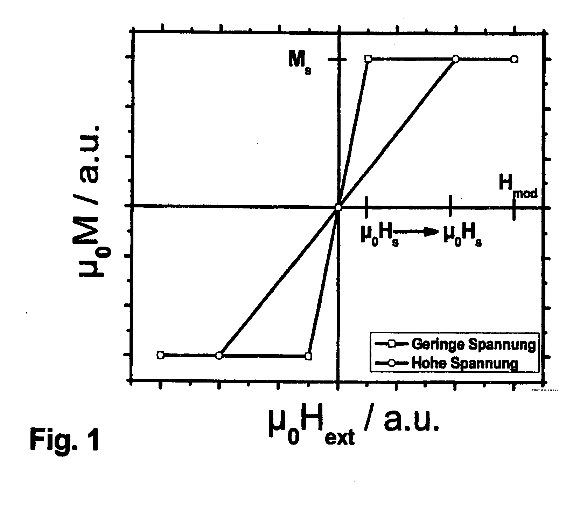

Vereinfachend soll im Folgenden zunächst von einer idealisierten Magnetisierungskurve ausgegangen werden [Fig. 1], die sich durch unten aufgeführte Eigenschaften beschreiben lässt:

- Die Sättigungsmagnetisierung $M_s$ wird bei der Feldstärke $H_k$ erreicht,

- die Suszeptibilität x ist für kleine Feldstärken unter dem Anisotropiefeld $H_k$ konstant und > 0; für Felder $H_{ext.} > H_k$ gilt x = 0. Damit gilt $x = \frac{M_s}{H_k}$ und

- durch Anlegen einer äußeren mechanischen Zugspannung $\sigma$ erhöht sich das Anisotropiefeld $H_k$, die Sättigungsmagnetisierung $M_s$ bleibt jedoch unverändert.

Damit verringert sich die Suszeptibilität mit zunehmender mechanischer Spannung bei positiv magnetostriktive Materialien, wenn die Richtung des Magnetfeldes und die Zugrichtung senkrecht zueinander stehen.

Damit lässt sich die Magnetisierungskurve durch

$$M(H_{ext.}) = \begin{cases} M_s \dfrac{H_{ext.}}{H_k} \; f\ddot{u}r - H_k \leq H_{ext.} \leq H_k \\ M_s \, f\ddot{u}r \left| H_{ext.} \right| > H_k \end{cases} \qquad (1)$$

und die Suszeptibilität durch

$$x(H_{ext.}) = \begin{cases} \dfrac{M_s}{H_k} \; f\ddot{u}r - H_k \leq H_{ext.} \leq H_k \\ 0 \, f\ddot{u}r \left| H_{ext.} \right| > H_k \end{cases} \qquad (2)$$

beschreiben.

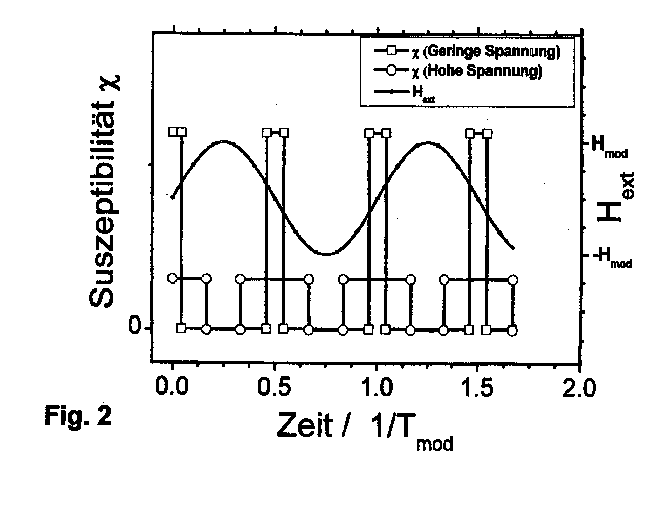

Unterliegt nun das Material mit obiger Magnetisierungskurve einem Wechselmagnetfeld $H_{ext.}(t) = H_{mod.} \cdot \sin(\omega_{mod.}t)$ mit $\omega_{mod.} = 2\pi f_{mod.}$ - wie in Fig. 2 dargestellt - so ergibt sich für die Suszeptibilität ein Rechtecksignal mit den oberen und unteren Werten x und 0 respektive. Zu beachten ist weiterhin, dass sich neben der Amplitude des Rechtecksignals auch das Zeitintervall, in dem das Signal den oberen der beiden Werte einnimmt - entspricht dem Tastverhältnis - mit unterschiedlichen Spannungszuständen verändert. Die Suszeptibilität als Funktion der Zeit lässt sich schreiben als:

$$x(t) = \begin{cases} \dfrac{M_s}{H_k} \; f\ddot{u}r - H_k \leq H_{mod.} \cdot \sin(\omega_{mod.}t) \leq H_k \\ 0 \, f\ddot{u}r \left| H_{mod.} \cdot \sin(\omega_{mod.}t) \right| > H_k \end{cases} \qquad (3).$$

Durch die Symmetrie der Magnetisierungskurve - es gilt $M(-H_{ext.}) = -M(H_{ext.})$ - hat das Rechtecksignal x(t) die halbe Periodendauer der Modulationsfrequenz $f_{mod.}$. Es gilt somit für die Periodendauer $T_0$ des Rechtecksignals:

$$T_0 = \frac{T_{mod.}}{2} \quad \text{und} \quad \omega_0 = \frac{2\pi}{T_0}.$$

Nun lässt sich das Frequenzspektrum des Rechtecksignals mittels Fourier-Transformation entwickeln. Es gelten hierfür die bekannte Synthese- und Analysegleichung. Sie zeigen, dass jedes Signal eine Grundfrequenz und ein Vielfaches von $\omega_0$ haben, so dass ein periodisches Signal durch das Gleichungspaar a) der Synthesegleichung

$$x(t) = \sum_{k=-\infty}^{k=\infty} a_k \cdot e^{jk\omega_0 t} \qquad (4)$$

und b) der Analysegleichung - auch als Fourier-Integral bekannt -

$$a_k = \frac{1}{T_0} \int_{T_0} x(t) \cdot e^{-jk\omega_0 t} dt \qquad (5)$$

definiert ist,

wobei die Absolutwerte von $a_k$ den Koeffizienten der Fourier-Reihe mit der Grundfrequenz $\omega_0$ entsprechen. Der Koeffizient $a_0$ ist hierbei der konstante Anteil von x(t) und lässt sich bestimmen durch

$$a_k = \frac{1}{T_0} \int_{T_0} x(t) dt = 2x \cdot \frac{T_1}{T_0}. \qquad (6)$$

Für $k \neq 0$ wird über das Intervall von $-\frac{T_0}{2}$ bis $+\frac{T_0}{2}$ integriert, was aufgrund der Symmetrie von *x(t)* um *t=0* günstig ist. $T_1$ sei der Zeitpunkt, bei dem das Rechtecksignal zum ersten Mal auf den Wert null fällt. Für den komplexen Fourier-Koeffizient $a_x$ von x(t) ergibt sich

$$a_k = \frac{1}{T_0} \int_{-T_1}^{T_1} x(t) \cdot e^{-jk\omega_0 t} dt = -\frac{x}{jk\omega_0 T_0} \cdot e^{-jk\omega_0 t} \Big|_{-T_1}^{+T_1}$$

$$= \frac{2x}{k\omega_0 T_0} \left[ \frac{e^{jk\omega_0 T_1} - e^{-jk\omega_0 T_1}}{2j} \right] = \frac{2x \sin(k\omega_0 T_1)}{k\omega_0 T_0}$$

und mit $\omega_0 T_0 = 2\pi$ gilt weiter

$$a_k = \frac{x}{k\pi} \sin(k\omega_0 T_1). \qquad (7)$$

Der Zeitpunkt $T_1$ lässt sich durch die Grenzen von Gleichung (3) im Verhältnis von $H_k$ zu $H_{mod.}$ ausdrücken.

Aus $H_k = H_{mod.} \sin(\omega_{mod.} T_1)$ folgt $T_1 = \dfrac{1}{\omega_{mod.}} \arcsin(\dfrac{H_k}{H_{mod.}})$ und mit $\omega_{mod.} = \dfrac{\omega_0}{2}$ wird

$$T_1 = \frac{2}{\omega_0} \arcsin(\frac{H_k}{H_{mod.}}) .$$ Gleichung (7) ergibt dann zusammen mit $x = \dfrac{M_s}{H_k}$

$$a_k = \frac{M_s}{k\pi H_k} \sin[2k \arcsin(\frac{H_k}{H_{mod.}})] \text{ für } k \neq 0 \tag{8}$$

und mit der Gleichung (6)

$$a_0 = \frac{M_s}{\pi H_k} \arcsin(\frac{H_k}{H_{mod.}}). \tag{9}$$

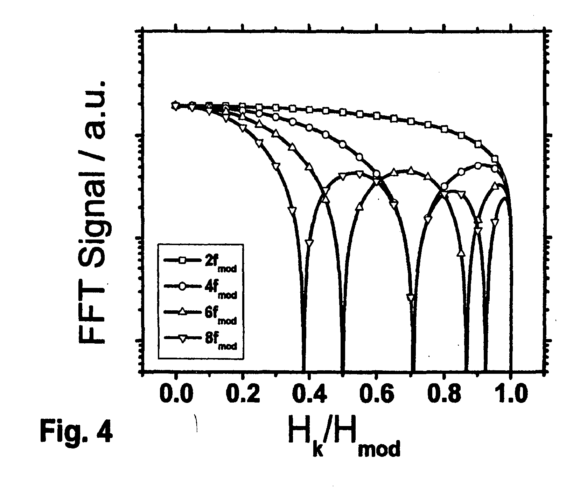

Die Koeffizienten der Fourier-Reihe können damit für ein gegebenes Verhältnis von $H_k$ zu $H_{mod.}$ bestimmt werden. Die Koeffizienten für k = 1, ..., 4 sind in Fig. 4 als Funktion dieses Verhältnisses abgebildet. Um das Rechtecksignal und seine Kanten mit geringem Fehler abzubilden, wäre eine Betrachtung bis hin zu hohen Harmonischen notwendig. Da die Amplitude mit steigendem $k$ mit $1/k$ abnimmt, werden in diesem Verfahren nur die ersten vier Harmonischen der Messfrequenz $f_0$, d. h. die ersten vier geraden Harmonischen der Modulationsfrequenz $f_{mod.}$ für die Analyse herangezogen. Betrachtet man zudem eine reale Suszeptibilität als Funktion eines externen Magnetfeldes, so gleicht diese ohnehin eher einer Glockenkurve ohne die abrupten Sprünge des hier betrachteten Rechtecksignals.

Gemäß Gleichung (8) kann das Auftreten der Nullstellen der $a_k$ (für $k = 1, ..., 4$; siehe Fig. 4) tabellarisch zusammengefasst werden. Tab. 1 zeigt hierfür eine der Möglichkeiten. Dabei ist in der ersten Zeile dasjenige Verhältnis von $H_k$ zu $H_{mod.}$ angegeben, bei dem eines oder mehrere der Fourier-Koeffizienten $a_k$ zu null wird. Der Arkussinus dieses Verhältnisses entspricht einem Bruchteil von $\pi$, welcher multipliziert mit $2k$ für *bestimmte k* ein Vielfaches von n ergibt. Dies wiederum führt zur Nullstelle des Fourier-Koeffizienten $a_k$.

Tabelle 1

| | 0.3827 | 0.5000 | 0.7071 | 0.8660 | 0.9239 | 1.0000 |
|---|---|---|---|---|---|---|
| | $\pi/8$ | $\pi/6$ | $\pi/4$ | $\pi/3$ | $3\pi/8$ | $\pi/2$ |
| $a_k=0$ für $k=$ | 4 | 3 | 2,4 | 3 | 4 | 1, 2, 3, 4 |

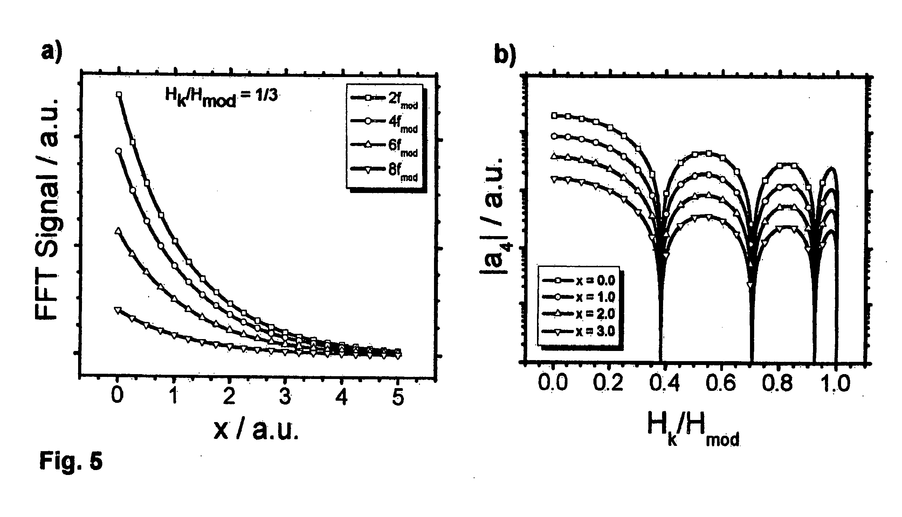

Die Amplitude der Koeffizienten nimmt also exponentiell mit dem Abstand zwischen der Messspule und dem magnetischen Material ab. Die Koeffizienten lassen sich demnach durch $a_k = a_{k,0} e^{-x/b}$ beschreiben, wobei $a_{k,0}$ den Koeffizient bei einem Abstand von x = 0 angibt. Die Figuren 5a und 5b stellen die Abhängigkeit der Koeffizient von x grafisch dar.

Die Fourier-Koeffizienten nehmen also exponentiell mit zunehmendem Abstand x zwischen Messspule und Material ab. Die charakteristischen lokalen Minima treten auch bei zunehmendem Abstand an den gleichen $H_k$ zu $H_{mod}$ auf.

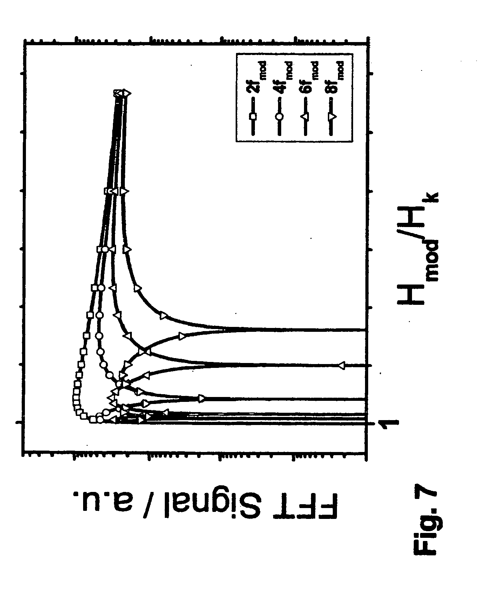

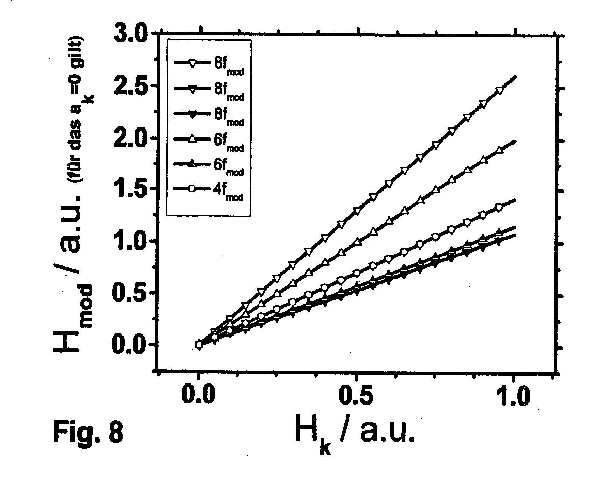

Das Verhältnis $H_k$ zu $H_{mod}$ ist demnach entscheidend für die Entstehung von lokalen Minima. So lässt sich umgekehrt auch für jeden Spannungszustand - gekennzeichnet durch ein bestimmtes $H_k$ - das entsprechende Modulationsfeld finden, bei dem ein lokales Minimum auftritt. Die Fourier-Koeffizienten lassen sich nach Gleichung (7) auch für ein sich veränderndes $H_{mod}$ bei konstantem $H_k$ berechnen, wie in Fig. 7 dargestellt. Die Werte des Modulationsfeldes, bei denen Nullstellen der jeweiligen $a_k$ für ein bestimmtes $H_k$ auftreten, sind für $k = 2, 3,$ 4 in Fig. 8 gezeigt. Bei konstantem $H_k$ bleibt die Magnetisierungskurve also unverändert. Das Rechtecksignal ändert sich somit bei Variation von $H_{mod.}$ allein in seinem Tastverhältnis. Die Fourier-Koeffizienten zeigen erneut die Nullstellen bei den entsprechenden Verhältnissen von $H_k$ zu $H_{mod.}$, bzw. $H_{mod.}$ zu $H_k$.

Das Modulationsfeld, bei dem Nullstellen auftreten, ist demnach proportional zum Anisotropiefeld des Materials.

Durch die Variation des Modulationsfeldes lässt sich also ein bestimmter Fourier-Koeffizient, z. B. $a_4$, auf den Wert null minimieren. Der Wert des Modulationsfeldes ist in dieser Nullstelle entsprechend proportional zum Anisotropiefeld des Materials, das wiederum durch den Spannungszustand gekennzeichnet ist. Ändert sich der Spannungszustand des Materials und damit $H_k$, kann das Modulationsfeld entsprechend angepasst werden, damit der Fourier-Koeffizient weiterhin null beträgt. Diese Möglichkeit der Variation des Modulationsfeldes $H_{mod.}$ Liefert also eine weitere Möglichkeit der Signalauswertung.

**Patentansprüche**

1. Verfahren zur Bestimmung mechanischer Eigenschaften magnetostriktiver Materialien, mit den folgenden Schritten:

    Einbringen des Materials in ein externes Wechselmagnetfeld unter periodischem Sättigen des magnetischen Materials,
    Aufbringen einer senkrecht zu der Magnetfeldrichtung verlaufenden wechselnden mechanischen Zugspannungsbeanspruchung,
    Gewinnen eines charakteristischen Verlaufs der Suszeptibilität bei verschiedenen Zugbeanspruchungen,
    Bestimmen der Koeffizienten einer Fourier-Reihe aus den Verläufen der Suszeptibiltät und
    Ermitteln der Koeffizienten der sich als lokale Minima darstellenden Nullstellen der Fourier-Funktion.

2. Verfahren nach Anspruch 1, **gekennzeichnet durch** Berücksichtigen allein der Nullstellen einer bestimmten harmonischen Oberschwingung.

3. Verfahren nach Anspruch 1 oder 2, **gekennzeichnet durch** Anpassen des modulierten Magnetfelds derart, dass der Fourier-Koeffizient bei den verschiedenen Zugspannungsbelastungen des magnetischen Materials null wird.

**Claims**

1. A method for determining mechanical properties of magnetostrictive materials, having the following steps:

    introducing the material into an external alternating magnetic field with periodically saturating the magnetic material,
    applying an alternating mechanical tensile stress that extends perpendicular to the direction of the magnetic field,
    obtaining a characteristic behavior of the susceptibility for different tensile stresses,
    determining the coefficient of a Fourier series from the susceptibility behavior and
    establishing the coefficients of the zeroes of the Fourier function that appear as local minima.

2. The method according to claim 1, **characterized by** taking into account only the zeroes of a specific harmonic.

3. The method according to claim 1 or 2, **characterized by** matching the modulated magnetic field such that the Fourier coefficient becomes zero for the different tensile stresses of the magnetic material.

**Revendications**

1. Procédé de détermination des caractéristiques mécaniques de matériaux magnétorestrictifs, avec les étapes suivantes :

    Introduction du matériau dans un champ magnétique alternatif externe avec saturation périodique du matériau magnétique,
    Application d'une contrainte de traction mécanique alternative perpendiculaire à la direction du champ magnétique,
    Obtention d'une courbe caractéristique de la sensibilité sous diverses contraintes de traction,
    Détermination des coefficients d'une série de Fourier à partir des courbes de sensibilité et
    Détermination des coefficients des valeurs nulles de la fonction de Fourier représentées comme minima locaux.

2. Procédé selon la revendication 1, **caractérisé par** la seule prise en compte des valeurs nulles d'un harmonique déterminé.

3. Procédé selon la revendication 1 ou 2, **caractérisé par** l'adaptation du champ magnétique modulé de telle sorte que le coefficient de Fourier devienne égal à nul sous les diverses contraintes de traction du matériau magnétique.

Fig. 1

Fig. 2

Fig. 3

Fig. 4

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3534460 A1
- DE 3624846 A1
- DE 3620412 A1
- US 389855 A

**In der Beschreibung aufgeführte Nicht-Patentliteratur**

- Non-contact strain measurement. *Sensors and Actuators A,* 2010, vol. 158, 224-230